# EUROPÄISCHE PATENTSCHRIFT

(11) **EP 1 921 906 B1**
(45) Veröffentlichungstag und Bekanntmachung des Hinweises auf die Patenterteilung: **11.12.2019**
(21) Anmeldenummer: 07118227.3
(22) Anmeldetag: 10.10.2007
(51) Int. Cl.: H05K 5/02, H05K 5/06

(54) **Druckausgleichsvorrichtung für ein Gehäuse**
Pressure compensation element for a casing
Dispositif d'équilibrage de pression pour un boîtier

(30) Priorität: 10.11.2006 DE 102006053111
(43) Veröffentlichungstag der Anmeldung: 14.05.2008
(73) Patentinhaber: ROBERT BOSCH GMBH, 70442 Stuttgart (DE)
(72) Erfinder: Geissler, Alexander, 07616, Buergel (DE); Hennel, Udo, 74321, Bietigheim-Bissingen (DE)

(56) Entgegenhaltungen:
- DE-A1-102004 056 662
- DE-U1-202005 018 557
- GB-A- 2 330 952

## Beschreibung

Die Erfindung betrifft eine Druckausgleichsvorrichtung für ein eine elektrische Schaltung aufnehmendes Gehäuse eines Fahrzeugs, insbesondere für das Gehäuse eines Steuergeräts eines Kraftfahrzeugs, mit einer in kommunizierende Verbindung mit dem Inneren des Gehäuses bringbaren, semipermeablen Membran nach dem Patentanspruch 1.

### Stand der Technik

Druckausgleichsvorrichtungen für ein abgedichtetes Gehäuse einer elektrischen Schaltung sind im Stand der Technik geläufig. Insbesondere werden sie für Steuergeräte von Kraftfahrzeugen eingesetzt. Durch sehr weiten thermischen und barometrischen Einsatzbereich der Anwendungen bedürfen solche abgedichteten Gehäuse eines Druckausgleichs, da durch Erwärmung und Abkühlung der elektrischen beziehungsweise elektronischen Schaltungen und ihres abgedichteten Gehäuses die Dichtungen und Verbindungsstellen stark belastet werden. Der Druckausgleich erfolgt über eine semipermeable Membran der Druckausgleichsvorrichtung, wobei die Membran im Regelfall direkt über einer das Innere des Gehäuses mit der Gehäuseumgebung verbindenden Öffnung angebracht ist. Dazu ist die Membran zum Beispiel auf das Gehäuse geklebt, geschweißt oder durch eine Kunststoffumspritzung fixiert. Die semipermeable Membran lässt Luft oder auch Wasserdampf durch, stellt jedoch für Flüssigkeiten wie zum Beispiel Wasser eine Barriere dar. Um die mechanisch sehr empfindliche Membran der Druckausgleichsvorrichtung in Verbindung mit einem Gehäuse für eine elektrische Schaltung verwenden zu können, bedarf es eines mechanischen Schutzes, um eine Beschädigung der Membran vermeiden zu können. Dabei muss die Membran insbesondere vor einem direkten, zielgerichteten mechanischen Zugriff geschützt werden. Dieser mechanische Zugriff kann zum Beispiel bei einem Steuergerät eines Fahrzeugs durch den Wasserstrahl eines Hochdruckreinigers erfolgen.

Die Offenlegungsschrift GB 2 330 952 A zeigt zwei Ausführungsformen eines Druckausgleichselements. Die eine Ausführungsform gemäß Figur 4 zeigt eine als Schutzkappe ausgebildete Schutzvorrichtung (230), die einen Zwischenraum zu einer Membran (220) bildet und einen radial von dem Zwischenraum nach außen verlaufenden Belüftungsweg (250) bildet.

Die Offenlegungsschrift DE 10 2004 056 662 A1 zeigt eine Druckausgleichsvorrichtung, die eine Schutzkappe mit in ihrer Mantelfläche versehenen Öffnungen umfasst.

### Offenbarung der Erfindung

Die erfindungsgemäße Druckausgleichsvorrichtung weist eine die Membran abdeckende Schutzvorrichtung auf, die durch Abstand zur Membran einen Zwischenraum zu dieser ausbildet, der über mindestens einen winkelförmig verlaufenden Belüftungsweg, kommunizierend mit der Umgebungsluft in Verbindung steht. Durch den winkelförmig verlaufenden Belüftungsweg wird ein direkter Zugriff - das heißt ein Zugriff auf direktem Wege - von der Umgebung der Druckausgleichsvorrichtung auf die Membran unterbunden wobei die Funktion der Druckausgleichsvorrichtung vollständig erhalten bleibt. Besteht der mechanische Einfluss zum Beispiel aus einem zielgerichteten Flüssigkeitsstrahl, so entsteht durch die winkelförmige Ausgestaltung des Belüftungswegs im Bereich der Winkel ein Staudruck , sodass der Flüssigkeitsstrahl beim Eindringen in den Belüftungsweg nicht in Richtung der Membran gelenkt oder geführt wird. Durch den entstehenden Staudruck kann die gezielte Kraftwirkung des Wasserstrahls nicht direkt auf die Membran wirken und diese schädigen.

In einer bevorzugten Ausführungsform ist vorgesehen, dass der Belüftungsweg einen gekröpften Verlauf aufweist. Ein solcher winkelförmiger, gekröpfter Verlauf, verhindert einen direkten Zugriff auf die Membran bei einem kurzen Belüftungsweg besonders effektiv.

Weiterhin ist vorgesehen, dass der Belüftungsweg labyrinthartig laufend ausgebildet ist. Unter labyrinthartig ist in diesem Zusammenhang zu verstehen, dass es sich um einen indirekt verlaufenden Weg mit winkelförmiger Streckenführung handelt. Der gerichtete Druck eines Flüssigkeitsstrahls kann besonders effektiv in einen ungerichteten Druck verwandelt werden.

Allgemein ist vorgesehen, dass die Schutzvorrichtung als Schutzplatte oder Schutzkappe ausgebildet ist. Eine derartige Ausbildung der Schutzvorrichtung verhindert einen direkten Zugriff auf die Membran "von oben". Während eine Schutzkappe die Membran selbsttragend überdecken kann wird eine plane Schutzplatte mittels mindestens eines einen Zwischenraum zwischen Membran und Schutzplatte bildenden Abstandselements über der Membran angeordnet.

In einer weiteren bevorzugten Ausführungsform ist vorgesehen, dass die Schutzvorrichtung eine direkt auf dem Gehäuse befestigbare Befestigungsfläche aufweist. Eine derartige Schutzvorrichtung ist zum Beispiel als Schutzkappe mit einem Kappendeckel- und einem Kappenseitenbereich, der bei direkter Befestigung der Schutzvorrichtung auf dem Gehäuse den Abstand zur Membran ausbildet, wobei ein Zwischenraum zwischen Membran und Schutzvorrichtung entsteht.

Weiterhin ist vorgesehen, dass die Membran einen direkt auf das Gehäuse anordenbare Membran ist. Die Membran ist dabei zum Beispiel über eine Öffnung einer Gehäusewand des Gehäuses befestigt, das den Gehäuseinnenraum mit der Gehäuseaußenseite verbindet. Die Befestigung der semipermeablen Membran auf dem Gehäuse kann dabei durch eine Klebung, Schweißung oder eine Kunststoffumspritzung realisiert sein.

Allgemein ist vorgesehen, dass der Belüftungsweg an der der Membran zugewandten Innenseite der Schutzplatte oder Schutzkappe als Vertiefung ausgebildet ist. Dabei wird der Zwischenraum insbesondere von der Vertiefung mitgebildet.

Insbesondere ist vorgesehen, dass die Vertiefung als nutartiger Kanal ausgebildet ist. Dieser nutartige Kanal hat einen winkelförmigen, insbesondere gekröpften Verlauf.

Nach einer Weiterbildung der Erfindung ist vorgesehen, dass die Schutzvorrichtung eine Abdeckung und ein Zwischenelement aufweist, das zwischen der Abdeckung und dem Gehäuse angeordnet ist. Die Abdeckung verhindert einen Zugriff "von oben" auf die Membran und kann optional den Belüftungsweg und den Zwischenraum ausbilden oder mit ausbilden. Alternativ oder zusätzlich können der Belüftungsweg und/oder der Zwischenraum auch vom Zwischenelement gebildet beziehungsweise mitgebildet werden.

Allgemein ist vorgesehen, dass das Zwischenelement mindestens eine Aussparung entlang des in der Abdeckung ausgebildeten Belüftungswegs aufweist. Werden Zwischenraum und Belüftungsweg als Aussparung in der Abdeckung ausgebildet oder mit ausgebildet, so kann insbesondere der Belüftungsweg von dem Zwischenelement mitgebildet werden.

In einer weiteren Ausführungsform der Erfindung ist vorgesehen, dass die Aussparung als das Zwischenelement durchsetzender Durchbruch ausgebildet ist.

Weiterhin ist vorgesehen, dass das Zwischenelement als Zwischenplatte ausgebildet ist. Die Zwischenplatte kann dabei Aussparungen, insbesondere Aussparungen entlang des in der Abdeckung ausgebildeten Belüftungswegs aufweisen.

Alternativ oder zusätzlich ist vorgesehen, dass das Zwischenelement als Halter für die Abdeckung ausgebildet ist. Dabei wird die Abdeckung auf dem Halter befestigt, der seinerseits zum Beispiel mit dem Gehäuse befestigbar ist.

Nach einer Weiterbildung der Erfindung ist vorgesehen, dass das Zwischenelement ein doppelseitig klebender Träger ist. Dabei kann das Zwischenelement als Halter für die Abdeckung und/oder die Membran ausgebildet sein. Der doppelseitig klebende Träger weist insbesondere entlang des in der Abdeckung ausgebildeten Belüftungswegs eine Aussparung auf, um ein Verkleben im Bereich des Belüftungswegs zu vermeiden.

Insbesondere ist vorgesehen, dass die Membran an dem Zwischenelement befestigt ist oder auch an dem Zwischenelement befestigt ist. Ist die Membran zum Beispiel zwischen dem Zwischenelement und der Abdeckung befestigt, insbesondere verklebt, so wird die Membran einerseits durch die Klebung am Zwischenelement, andererseits durch eine Klemmung zwischen dem verklebten Zwischenelement und der Abdeckung gehalten.

Weiterhin sind mehrere Belüftungswege vorgesehen, die winkelversetzt zueinander verlaufend angeordnet sind. Dabei sind zum Beispiel drei einen identisch gekröpften Verlauf aufweisende Belüftungswege um 120° gegeneinander versetzt angeordnet. Diese Belüftungswege sind zum Beispiel in der Schutzplatte oder Schutzkappe beziehungsweise der Abdeckung und/oder dem Zwischenelement ausgebildet.

Die Erfindung betrifft weiterhin ein Gehäuse für eine elektrische Schaltung, insbesondere für eine Steuergerätschaltung eines Kraftfahrzeugs, mit einer vorstehend genannten Druckausgleichsvorrichtung. Dabei ist die semipermeable Membran und die die Membran abdeckende Schutzvorrichtung zum Beispiel direkt über einer Öffnung einer Gehäusewand des Gehäuses befestigt. Die Befestigung der semipermeablen Membran ist dabei eine Klebung, eine Schweißung oder eine Kunststoffumspritzung. Die Schutzvorrichtung ist in diesem Fall ebenfalls direkt auf der Gehäuseaußenseite geklebt, geschweißt oder durch eine Kunststoffumspritzung befestigt. Relativ kann ein Zwischenelement vorgesehen sein, das die Membran und/oder die Schutzvorrichtung zumindest teilweise trägt und an der Gehäuseaußenseite befestigt.

### Kurze Beschreibung der Zeichnungen

- Figur 1: zeigt einen Schnitt durch eine Gehäusewand mit einer Öffnung und eine erfindungsgemäße Druckausgleichvorrichtung mit einer Schutzvorrichtung und einer semipermeablen Membran,
- Figuren 2A und 2B: verschiedene Ansichten der die Membran abdeckenden Schutzvorrichtung der Figur 1 und
- Figuren 3A bis 3F: den Aufbau und die Montage einer Druckausgleichsvorrichtung nach einem zweiten Ausführungsbeispiel.

### Ausführungsform(en) der Erfindung

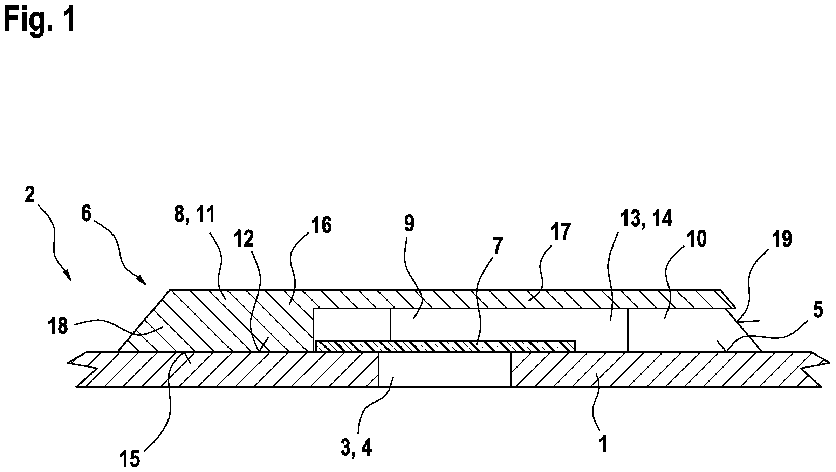

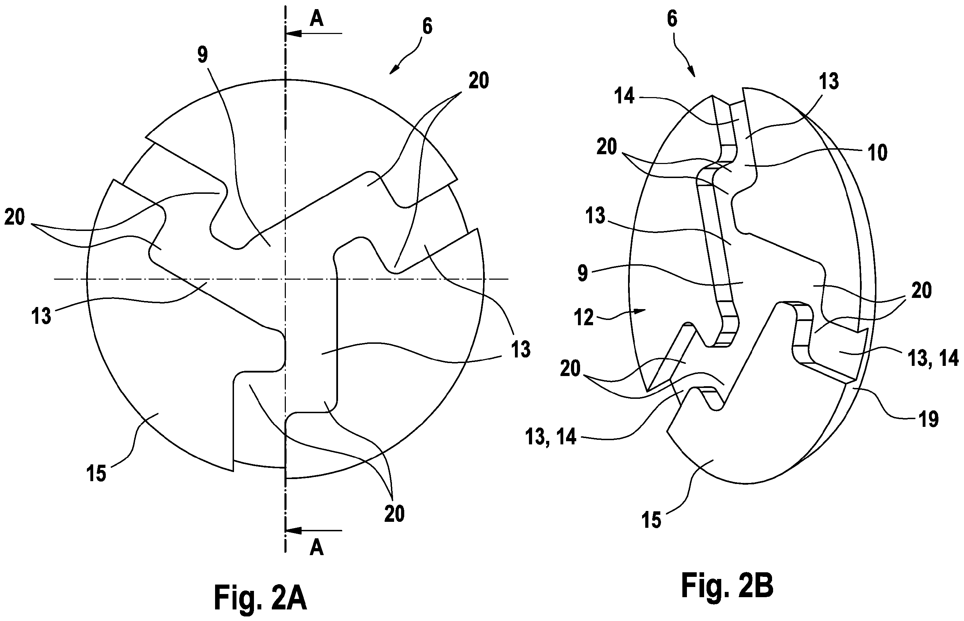

Die Figur 1 zeigt eine Gehäusewand 1 eines Gehäuses 2 mit einem als Öffnung 3 ausgebildeten Durchbruch 4. Die Öffnung 3 verbindet das Innere des Gehäuses 2 mit der Umgebung des Gehäuses 2. Auf der Außenseite 5 der Gehäusewand 1 ist über der Öffnung 3 eine Druckausgleichsvorrichtung 6 mit einer semipermeablen Membran 7 und einer die Membran abdeckenden Schutzvorrichtung 8 angeordnet. Die die Membran 7 abdeckende Schutzvorrichtung 8 bildet oberhalb der Membran 7 einen Zwischenraum 9 aus, der über drei Belüftungswege 10, von denen in der Schnittdarstellung der Figur 1 lediglich ein Lüftungsweg dargestellt ist, mit der Umgebungsluft in Verbindung steht. Die Darstellung der Schutzvorrichtung 8 der Figur 1 ist eine Darstellung entlang der in der Figur 2A gezeigten Schnittlinie A-A. Die Schutzvorrichtung 8 der Figur 1 beziehungsweise der Figuren 2A und 2B ist als Schutzplatte 11 ausgebildet, bei der die Belüftungswege 10 an der der Membran 7 zugewandten Innenseite 12 der Schutzplatte 11 als Vertiefungen 13 ausgebildet sind. Wie Figur 2B deutlich zeigt, sind diese Vertiefungen 13 nutartige Kanäle 14. Die verbleibende Fläche der Innenseite 12 ist die Befestigungsfläche 15, mit dem die Schutzvorrichtung 8 direkt auf dem Gehäuse 2 befestigt ist. Durch die Ausbildung der Belüftungswege 10 und des Zwischenraums 9 als Vertiefungen 13 in einer Schutzvorrichtung 8 wird eine Schutzkappe 16 ausgebildet. Die Schutzkappe 16 weist einen Deckelteil 17 und mindestens ein Seitenteil 18 auf, wodurch die Schutzkappe 16 den Zwischenraum 9 bei direkter Montage auf dem Gehäuse 2 selbst ausbildet.

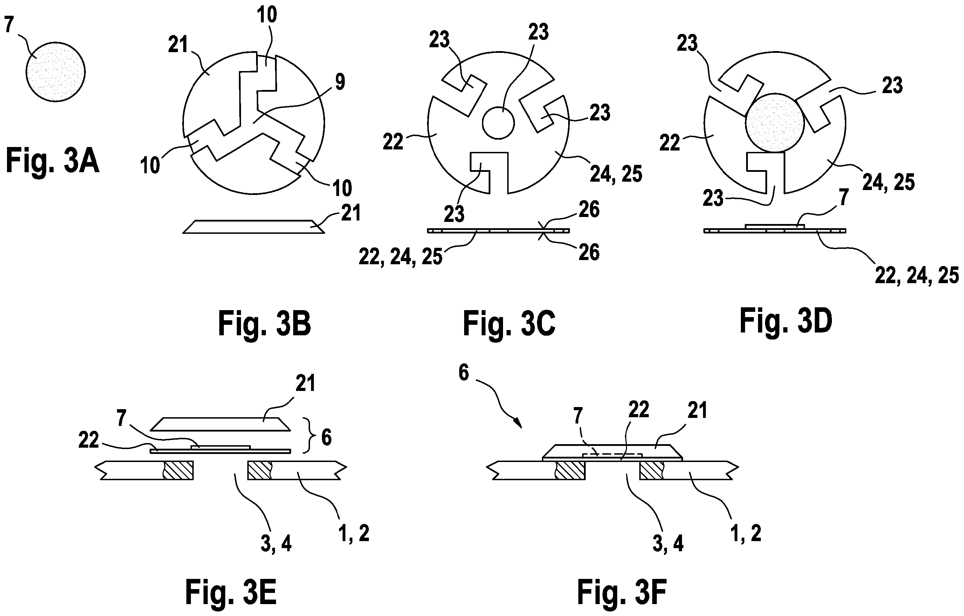

Die Figuren 2A und 3B zeigen zwei Ansichten der Schutzvorrichtung 8 der Figur 1. Die Figur 2A zeigt eine Ansicht "von unten" auf die Innenseite 12 der Schutzvorrichtung 8 mit Vertiefungen 13 dargestellt. In der Mitte der Druckausgleichsvorrichtung 6 ist der Teil der Vertiefungen 13, der den Zwischenraum 9 bildet. Von diesem Teil der Vertiefung 13 gehen drei nutartige Kanäle 14 ab, die sich von dem Zwischenraum 9 bis zur Außenkante 19 des Seitenteils 18 erstrecken. Diese nutartigen Kanäle bilden winkelförmig verlaufende Belüftungswege 10, die in dem konkreten Ausführungsbeispiel einen gekröpften Verlauf aufweisen. Insgesamt sind die Belüftungswege 10 damit labyrinthartig verlaufend ausgebildet. Die Figur 2B zeigt die Schutzvorrichtung 8 in einer weiteren Darstellung, die die Vertiefungen 13 beziehungsweise nutartigen Kanäle 14 besser erkennen lässt.

Es ergibt sich folgende Funktion der Druckausgleichsvorrichtung 6 mit der Schutzvorrichtung 8 und der semipermeablen Membran 7: Die auf der Öffnung 3 angebrachte Membran 7 sorgt für einen Druckausgleich des Innenraums des Gehäuses 2 mit der Umgebungsluft des Gehäuses 2. Dabei können Gase wie Luft oder auch Wasserdampf die semipermeable Membran 7 passieren, während die Membran 7 für Flüssigkeiten wie zum Beispiel Wasser eine Barriere darstellt. Um die Membran 7 vor einem mechanischen Zugriff zu schützen, ist die die Membran 7 abdeckende Schutzvorrichtung 8 oberhalb der Membran 7 auf dem Gehäuse 2 angeordnet. Damit die Membran 7 auch vor dem Druck eines Flüssigkeitsstrahls wie zum Beispiel dem Wasserstrahl eines Hochdruckreinigers optimal geschützt ist, sind die Belüftungswege 10 in der Schutzvorrichtung 8 winkelförmig verlaufend ausgebildet. Durch die winkelförmige Ausbildung steht die Membran 7 kommunizierend mit der Umgebungsluft der Druckausgleichsvorrichtung 6 in Verbindung, schützt jedoch vor einem direkten Zugriff von außen auf die Membran 7. Ein in den Außenbereich eines der Belüftungswege 10 eindringender Flüssigkeitsstrahl wird durch den winkelförmigen Verlauf des Belüftungswegs 10 nicht in Richtung der Membran 7 gelenkt oder geführt. Durch die winkelförmige Ausgestaltung entsteht im Bereich der Winkel 20 ein Staudruck, der die gezielte Kraftwirkung des Wasserstrahls verhindert. Durch den gekröpften Verlauf des Belüftungswege 10 mit mehreren Winkeln 20 wird dieser Effekt auch bei kurzen Distanzen zwischen der Außenkante 19 der Schutzvorrichtung 8 zum Zwischenraum 9 gewährleistet. Durch die labyrinthartige Ausbildung der Belüftungswege 10 ist gewährleistet, dass auch durch eingedrungene Flüssigkeit in einen der Belüftungswege 10 ein Druckausgleich gewährleistet bleibt.

Die Figuren 3A bis 3F zeigen den Aufbau und die Montage einer erfindungsgemäßen Druckausgleichsvorrichtung 6 nach einem zweiten Ausführungsbeispiel. Dabei weist die Schutzvorrichtung 8 eine schutzkappenartige Abdeckung 21 und ein Zwischenelement 22 auf, das als Halter für die Abdeckung 21 ausgebildet ist. Dazu ist das Zwischenelement 22 zwischen der Abdeckung 21 und dem Gehäuse 2 angeordnet. Die Belüftungswege 10 sind als nutartige Kanäle 14 in der Abdeckung 21 ausgebildet, wobei das Zwischenelement 22 jeweils eine Aussparung 23 entlang der in der Abdeckung 21 ausgebildeten Belüftungswege 10 und des Zwischenraums 9 aufweist. Das Zwischenelement 22 ist dabei als Halter 24 für die Abdeckung 21 und die Membran 7 ausgebildet. Dazu ist das Zwischenelement 22 ein doppelseitig klebender Träger 25 mit zwei Klebeflächen 26 auf der Ober- und Unterseite des Trägers 25 ausgebildet. Die Figur 3A zeigt die Membran 7, die Figur 3B die Abdeckung 21 mit den Belüftungswegen 10 und dem Zwischenraum 9 und die Figur 3C das als doppelseitig klebender Träger 25 ausgebildete Zwischenelement 22 mit den Aussparungen 23. Die Figuren 3D bis 3F zeigt den Zusammenbau und die Montage der Druckausgleichsvorrichtung 6. Dazu wird zunächst die semipermeable Membran 7 auf der Oberseite des Zwischenelements 22 auf die entsprechende Aussparung 23 aufgeklebt (Figur 3D). Anschließend wird das als Träger 25 ausgebildete Zwischenelement 22 auf das Gehäuse 2 über die Öffnung 3 geklebt, sodass die semipermeable Membran 7 direkt über der Öffnung 3 angeordnet ist. Anschließend wird die Abdeckung 21 so auf der Oberseite des Zwischenelements 22 aufgeklebt, dass die Aussparungen 23 des Trägers 25 entlang der in der Abdeckung 21 ausgebildeten Belüftungswege 10 verlaufen. Das Verkleben des Zwischenelements 22 auf dem Gehäuse 2 und der Abdeckung 21 beziehungsweise der Membran 7 auf dem Zwischenelement 22 erfolgt über die Klebeflächen 26 des Trägers 25 (Figur 3E). Die Figur 3F zeigt die fertig montierte Druckausgleichsvorrichtung 6 auf dem Gehäuse 2 eines Steuergeräts 27 eines Kraftfahrzeugs.

## Patentansprüche

1. Druckausgleichsvorrichtung für ein eine elektrische Schaltung aufnehmendes Gehäuse eines Fahrzeugs, insbesondere für das Gehäuse eines Steuergeräts eines Kraftfahrzeugs, mit einer in kommunizierende Verbindung mit dem Innern des Gehäuses bringbaren, semipermeablen Membran, mit einer die Membran (7) abdeckenden Schutzvorrichtung (8), die durch Abstand zur Membran (7) einen Zwischenraum (9) zu dieser ausbildet, der über mindestens einen Belüftungsweg (10), kommunizierend mit der Umgebungsluft in Verbindung steht, wobei der Belüftungsweg (10) an der der Membran (7) zugewandten Innenseite (12) der als Schutzkappe (16) mit einem Deckelteil (17) und mindestens einem Seitenteil (18) ausgebildeten Schutzvorrichtung (8) als nutartiger Kanal (14) ausgebildet ist, **dadurch gekennzeichnet, dass** der nutartiger Kanal sich von dem Zwischenraum (9) bis zur Außenkante (19) des Seitenteils (18) winkelförmig erstreckt.

2. Druckausgleichsvorrichtung nach Anspruch 1, **dadurch gekennzeichnet, dass** der Belüftungsweg (10) einen gekröpften Verlauf aufweist.

3. Druckausgleichsvorrichtung nach einem der vorhergehenden Ansprüche, **dadurch gekennzeichnet, dass** der Belüftungsweg (10) labyrinthartig verlaufend ausgebildet ist.

4. Druckausgleichsvorrichtung nach einem der vorhergehenden Ansprüche, **dadurch gekennzeichnet, dass** die Schutzvorrichtung (8) eine direkt auf dem Gehäuse (2) befestigbare Befestigungsfläche (15) aufweist.

5. Druckausgleichsvorrichtung nach einem der vorhergehenden Ansprüche, **dadurch gekennzeichnet, dass** die Membran (7) eine direkt auf das Gehäuse (2) anordenbare Membran (7) ist.

6. Druckausgleichsvorrichtung nach einem der vorhergehenden Ansprüche, **dadurch gekennzeichnet, dass** der nutartige Kanal (14) als Vertiefung (13) ausgebildet ist.

7. Druckausgleichsvorrichtung nach einem der vorhergehenden Ansprüche, **dadurch gekennzeichnet, dass** die Schutzvorrichtung (8) eine Abdeckung (21) und ein Zwischenelement (22) aufweist, das zwischen der Abdeckung (21) und dem Gehäuse (2) angeordnet ist.

8. Druckausgleichsvorrichtung nach einem der vorhergehenden Ansprüche, **dadurch gekennzeichnet, dass** die Aussparung (23) als das Zwischenelement (22) durchsetzender Durchbruch ausgebildet ist.

9. Druckausgleichsvorrichtung nach einem der vorhergehenden Ansprüche, **dadurch gekennzeichnet, dass** das Zwischenelement (22) als Zwischenplatte ausgebildet ist.

10. Druckausgleichsvorrichtung nach einem der vorhergehenden Ansprüche, **dadurch gekennzeichnet, dass** das Zwischenelement (22) als Halter (24) für die Abdeckung (21) ausgebildet ist.

11. Druckausgleichsvorrichtung nach einem der vorhergehenden Ansprüche, **dadurch gekennzeichnet, dass** das Zwischenelement (22) ein doppelseitig klebender Träger (25) ist.

12. Druckausgleichsvorrichtung nach einem der vorhergehenden Ansprüche, **dadurch gekennzeichnet, dass** die Membran (7) an dem Zwischenelement (22) befestigt ist oder auch an dem Zwischenelement (22) befestigt ist.

13. Druckausgleichsvorrichtung nach einem der vorhergehenden Ansprüche, **gekennzeichnet durch** mehrere Belüftungswege (10), die winkelversetzt zueinander verlaufend angeordnet sind.

14. Gehäuse für eine elektrische Schaltung, insbesondere für eine Steuergerätschaltung eines Kraftfahrzeugs, mit einer Druckausgleichsvorrichtung nach einem oder mehreren der vorhergehenden Ansprüche.

## Claims

1. Pressure compensation device for a housing, accommodating an electrical circuit, of a vehicle, in particular for the housing of a control unit of a motor vehicle, having a semipermeable diaphragm which is able to be brought into communicating connection with the interior of the housing, having a protective device (8) which covers the diaphragm (7) and which, by way of a spacing to the diaphragm (7), forms an intermediate space (9) with respect thereto, said intermediate space being connected in a communicating manner to the ambient air via at least one venting path (10), wherein the venting path (10) is formed as a groove-like channel (14) on the inner side (12), facing the diaphragm (7), of the protective device (8), which is formed as a protective cap (16) having a cover part (17) and at least one side part (18), **characterized in that** the groove-like channel extends in an angled manner from the intermediate space (9) to the outer edge (19) of the side part (18).

2. Pressure compensation device according to Claim 1, **characterized in that** the venting path (10) has a cranked profile.

3. Pressure compensation device according to either of the preceding claims, **characterized in that** the venting path (10) is formed so as to extend in the manner of a labyrinth.

4. Pressure compensation device according to one of the preceding claims, **characterized in that** the protective device (8) has a fastening surface (15) which is able to be fastened directly on the housing (2).

5. Pressure compensation device according to one of the preceding claims, **characterized in that** the diaphragm (7) is a diaphragm (7) which is able to be arranged directly on the housing (2).

6. Pressure compensation device according to one of the preceding claims, **characterized in that** the groove-like channel (14) is formed as an indentation (13).

7. Pressure compensation device according to one of the preceding claims, **characterized in that** the protective device (8) has a cover (21) and an intermediate element (22) which is arranged between the cover (21) and the housing (2).

8. Pressure compensation device according to one of the preceding claims, **characterized in that** the cutout (23) is formed as an aperture passing through the intermediate element (22).

9. Pressure compensation device according to one of the preceding claims, **characterized in that** the intermediate element (22) is formed as an intermediate plate.

10. Pressure compensation device according to one of the preceding claims, **characterized in that** the intermediate element (22) is formed as a holder (24) for the cover (21).

11. Pressure compensation device according to one of the preceding claims, **characterized in that** the intermediate element (22) is a double-sided adhesive support (25).

12. Pressure compensation device according to one of the preceding claims, **characterized in that** the diaphragm (7) is fastened on the intermediate element (22) or is also fastened on the intermediate element (22).

13. Pressure compensation device according to one of the preceding claims, **characterized by** multiple venting paths (10) which are arranged so as to extend in a manner angularly offset with respect to one another.

14. Housing for an electrical circuit, in particular for a control unit circuit of a motor vehicle, having a pressure compensation device according to one or more of the preceding claims.

## Revendications

1. Dispositif d'équilibrage de pression pour un boîtier d'un véhicule accueillant un circuit électrique, notamment pour le boîtier d'un contrôleur d'un véhicule automobile, comprenant une membrane semi-perméable pouvant être amenée en liaison communicante avec l'intérieur du boîtier, comprenant un dispositif de protection (8) qui recouvre la membrane (7), lequel forme un espace intermédiaire (9) par rapport à la membrane (7) par un écart de celle-ci, lequel est en liaison communicante avec l'air ambiant par le biais d'au moins un trajet de ventilation (10), le trajet de ventilation (10) étant réalisé sous la forme d'un canal (14) de type rainure au niveau du côté intérieur (12) faisant face à la membrane (7) du dispositif de protection (8) configuré sous la forme d'un cache de protection (16) ayant une partie formant couvercle (17) et au moins une partie latérale (18), **caractérisé en ce que** le canal de type rainure s'étend avec une forme coudée de l'espace intermédiaire (9) jusqu'au bord extérieur (19) de la partie latérale (18).

2. Dispositif d'équilibrage de pression selon la revendication 1, **caractérisé en ce que** le trajet de ventilation (10) présente un tracé contrecoudé.

3. Dispositif d'équilibrage de pression selon l'une des revendications précédentes, **caractérisé en ce que** le trajet de ventilation (10) est configuré avec un tracé de type labyrinthe.

4. Dispositif d'équilibrage de pression selon l'une des revendications précédentes, **caractérisé en ce que** le dispositif de protection (8) possède une surface de fixation (15) qui peut être fixée directement sur le boîtier (2).

5. Dispositif d'équilibrage de pression selon l'une des revendications précédentes, **caractérisé en ce que** la membrane (7) est une membrane (7) qui peut être disposée directement sur le boîtier (2).

6. Dispositif d'équilibrage de pression selon l'une des revendications précédentes, **caractérisé en ce que** le canal (14) de type rainure est réalisé sous la forme d'une empreinte (13).

7. Dispositif d'équilibrage de pression selon l'une des revendications précédentes, **caractérisé en ce que** le dispositif de protection (8) possède un chapeau (21) et un élément intermédiaire (22) qui est disposé entre le chapeau (21) et le boîtier (2).

8. Dispositif d'équilibrage de pression selon l'une des revendications précédentes, **caractérisé en ce que** l'évidement (23) est réalisé sous la forme d'un passage qui traverse l'élément intermédiaire (22).

9. Dispositif d'équilibrage de pression selon l'une des revendications précédentes, **caractérisé en ce que** l'élément intermédiaire (22) est réalisé sous la forme d'une plaque intermédiaire.

10. Dispositif d'équilibrage de pression selon l'une des revendications précédentes, **caractérisé en ce que** l'élément intermédiaire (22) est réalisé sous la forme d'un élément de maintien (24) pour le chapeau (21) .

11. Dispositif d'équilibrage de pression selon l'une des revendications précédentes, **caractérisé en ce que** l'élément intermédiaire (22) est un élément porteur (25) adhésif sur deux faces.

12. Dispositif d'équilibrage de pression selon l'une des revendications précédentes, **caractérisé en ce que** la membrane (7) est fixée à l'élément intermédiaire (22) ou est également fixée à l'élément intermédiaire (22) .

13. Dispositif d'équilibrage de pression selon l'une des revendications précédentes, **caractérisé par** plusieurs trajets de ventilation (10) qui sont disposés avec un tracé en décalage angulaire les uns par rapport aux autres.

14. Boîtier pour un circuit électrique, notamment pour un circuit de contrôleur d'un véhicule automobile, comprenant un dispositif d'équilibrage de pression selon l'une ou plusieurs des revendications précédentes.
